# EUROPEAN PATENT APPLICATION

(11) **EP 4 589 616 A1**
(43) Date of publication of application: **23.07.2025**
(21) Application number: 24152895.9
(22) Date of filing: 19.01.2024
(51) Int. Cl.: H01H 11/00, G01H 1/00

(54) **CIRCUIT BREAKER MONITORING SYSTEM**

(71) Applicant: ABB SCHWEIZ AG, 5400 Baden (CH)
(72) Inventor: LOSS, Theresa, 68167 Mannheim (DE); BOYACI, Aydin, 76337 Waldbronn (DE); GITZEL, Ralf, 68165 Mannheim (DE); MIGUNOV, Vadim, 68526 Ladenburg (DE)
(74) Representative: Maiwald GmbH

(57) **Abstract**

The present invention relates to a circuit breaker monitoring system, comprising:
- a vibration sensor (10);
- a processing unit (20); and
- an output unit (30);
wherein the vibration sensor is configured to be mounted to a circuit breaker (100);
wherein the vibration sensor is configured to acquire temporal vibration data over at least a portion of a closing operation of the circuit breaker, wherein the at least a portion of the closing operation comprises: movement of a moveable contact towards a fixed contact;
wherein the vibration sensor is configured to provide the temporal vibration data to the processing unit;
wherein the processing unit is configured to convert the temporal vibration data into frequency vibration data;
wherein the processing unit is configured to determine a vibration signal based on the frequency vibration data;
wherein the processing unit is configured to determine a plurality of spectral indicators or a plurality of spectral points based on the vibration signal;
wherein the processing unit is configured to determine an indication of operational functionality of the circuit breaker, wherein the determination comprises analysis of the plurality of spectral indicators or the plurality of spectral points; and
wherein the output unit is configured to output information relating to the indication of operational functionality of the circuit breaker.

## Description

### FIELD OF THE INVENTION

The present invention relates to circuit breaker monitoring systems, circuit breaker monitoring methods, switchgears, as well as computer program elements.

### BACKGROUND OF THE INVENTION

The operating mechanism of a circuit breaker is one of the main subsystems prone to failure of a switchgear.

Monitoring of circuit breaker health is essential to detect abnormal behavior, guarantee safe operation and schedule maintenance and repairs.

However, circuit breakers comprise a mechanical system with many components/parts (e.g., levers, shafts, spring and damping elements, joints, bearings), that makes monitoring difficult.

Each single component can experience degradation, aging or failure, and hence impair the system behavior.

The primary focus in detecting degradation or other effects has been on detecting changes in the opening and closing times of the breaker over a period of time. However, long-term changes in a component's properties may also lead to gradual or sudden changes in opening and closing times. Therefore, monitoring these effects can increase sensitivity of monitoring methods, enable service scheduling and prevent subsequent failure.

Vibration monitoring (e.g., by using accelerometers) has successfully been applied to monitor the health of circuit breakers. As described above, focus has been set on analysis of the opening/closing time and the detection of changes in opening and closing times.

However, this does not always capture or detect all failures.

There is a need to address this issue.

### SUMMARY OF THE INVENTION

Therefore, it would be advantageous to have an improved technique to enable monitoring of a circuit breaker of a switchgear.

The object of the present invention is solved with the subject matter of the independent claims, wherein further embodiments are incorporated in the dependent claims.

In a first aspect, there is provided a circuit breaker monitoring system, comprising:
- a vibration sensor;
- a processing unit; and
- an output unit.

The vibration sensor is configured to be mounted to a circuit breaker. The vibration sensor is configured to acquire temporal vibration data over at least a portion of a closing operation of the circuit breaker. The at least a portion of the closing operation comprises: movement of a moveable contact towards a fixed contact. The vibration sensor is configured to provide the temporal vibration data to the processing unit. The processing unit is configured to convert the temporal vibration data into frequency vibration data. The processing unit is configured to determine a vibration signal based on the frequency vibration data. The processing unit is configured to determine a plurality of spectral indicators or a plurality of spectral points based on the vibration signal. The processing unit is configured to determine an indication of operational functionality of the circuit breaker, the determination comprising analysis of the plurality of spectral indicators or the plurality of spectral points. The output unit is configured to output information relating to the indication of operational functionality of the circuit breaker.

In an example, the vibration sensor comprises an accelerometer, a laser vibrometer, a gyroscope, or a microphone.

In an example, the conversion of the temporal vibration data into the frequency vibration data comprises utilization of a mathematical transformation.

In an example, the conversion of the temporal vibration data into the frequency vibration data comprises utilization of a Fourier transform, Hilbert transform, or Wavelet transform.

In an example, the determination of the vibration signal comprises application of one or more of: a moving average filter, a moving median filter, a low pass filter, a high pass filter, a bandpass filter, a wavelet denoising filter. Other types of filter could be utilized.

In an example, the determination of the vibration signal comprises segmentation of the frequency vibration data into a plurality of frequency sections. The determination of the plurality of spectral indicators or the plurality of spectral points comprises a determination of an energy of two or more frequency sections of the plurality of frequency sections.

Thus, for example the frequency vibration data could be segmented into 10 frequency sections and the algorithm is implemented into a low-level controller and only sections 1, 2, and 7 (for example) are utilized for energy determination.

In an example, the determining the plurality of spectral indicators or the plurality of spectral points comprises determining an energy of each frequency section of the plurality of frequency sections.

In an example, the determination of the plurality of spectral indicators or the plurality of spectral points comprises extraction of an amplitude and/or frequency of each local maximum and/or each local minimum of at least one local maximum and/or at least one local minimum of the vibration signal.

In an example, the analysis of the plurality of spectral indicators or the plurality of spectral points comprises analysis of the plurality of spectral indicators or the plurality of spectral points by a machine learning algorithm. The machine learning algorithm was trained on a plurality of reference spectral indicators or a plurality of reference spectral points of a moveable contact with respect to a fixed contact over at least a portion of a plurality of reference closing operations of at least one reference circuit breaker determined from a plurality of reference temporal vibration data over the at least a portion of the plurality of the reference closing operations of the at least one reference circuit breaker. The at least a portion of the reference closing operations comprised: movement of a moveable contact towards a fixed contact.

In an example, the trained machine learning algorithm comprises a Bayesian model or a Neural Network.

In an example, the analysis of the plurality of spectral indicators or the plurality of spectral points comprises a comparison of the plurality of spectral indicators or the plurality of spectral points with a plurality of reference spectral indicators or a plurality of reference spectral points of a moveable contact with respect to a fixed contact over at least a portion of a plurality of reference closing operations of at least one reference circuit breaker determined from a plurality of reference temporal vibration data over the at least a portion of the plurality of the reference closing operations of the at least one reference circuit breaker. The at least a portion of the reference closing operations comprised: movement of a moveable contact towards a fixed contact.

In an example, the plurality of reference spectral indicators or the plurality of reference spectral points are stored in a database.

In an example, the database is comprised within the processing unit.

In an example, the database is separate to the processing unit.

In an example, the comparison comprises: utilization of distance measurements between the plurality of spectral indicators or the plurality of spectral points with a plurality of reference spectral indicators or a plurality of reference spectral points and/or the comparison comprises: utilization of a system identification analysis.

In an example the system identification analysis comprises Principle Component Analysis.

In an example the system identification analysis comprises utilization of one or more autoencoders.

Other system identification analysis techniques can be utilized.

In an example, the at least a portion of the closing operation of the circuit breaker is the same as the at least a portion of the plurality of the reference closing operations of the at least one reference circuit breaker.

In an example, the at least a portion of the closing operation of the circuit breaker comprises initiation of the closing operation and/or latch release, and the at least a portion of the plurality of the reference closing operations of the at least one reference circuit breaker comprised initiation of the closing operation and/or latch release.

In an example, the at least a portion of the closing operation of the circuit breaker comprises contact touch of the moveable contact with the fixed contact and/or stop of movement of the moveable contact. The at least a portion of the plurality of the reference closing operations of the at least one reference circuit breaker comprised contact touch of the moveable contact with the fixed contact and/or stop of movement of the moveable contact.

In an example, at least some of the plurality of temporal vibration data over the at least a portion of the plurality of the reference closing operations of the at least one reference circuit breaker was synthetically generated by a circuit breaker vibration data generator.

In an example, the processing unit is configured to determine a prognostication result comprising utilization of the plurality of spectral indicators or the plurality of spectral points.

In an example, determination of the prognostication result comprises self-calibration, characterization and thresholding.

In an example, the prognostication result comprises an estimated remaining lifetime of the circuit breaker.

In a second aspect, there is provided a circuit breaker monitoring system, comprising:
- a vibration sensor;
- a processing unit; and
- an output unit.

The vibration sensor is configured to be mounted to a circuit breaker. The vibration sensor is configured to acquire temporal vibration data over at least a portion of an opening operation of the circuit breaker. The at least a portion of the opening operation comprises: movement of a moveable contact away from a fixed contact. The vibration sensor is configured to provide the temporal vibration data to the processing unit. The processing unit is configured to convert the temporal vibration data into frequency vibration data. The processing unit is configured to determine a vibration signal based on the frequency vibration data. The processing unit is configured to determine a plurality of spectral indicators or a plurality of spectral points based on the vibration signal. The processing unit is configured to determine an indication of operational functionality of the circuit breaker, the determination comprising analysis of the plurality of spectral indicators or the plurality of spectral points. The output unit is configured to output information relating to the indication of operational functionality of the circuit breaker.

In an example, the vibration sensor comprises an accelerometer, a laser vibrometer, a gyroscope, or a microphone.

In an example, the conversion of the temporal vibration data into the frequency vibration data comprises utilization of a mathematical transformation.

In an example, the conversion of the temporal vibration data into the frequency vibration data comprises utilization of a Fourier transform, Hilbert transform, or Wavelet transform.

In an example, the determination of the vibration signal comprises application of one or more of: a moving average filter, a moving median filter, a low pass filter, a high pass filter, a bandpass filter, a wavelet denoising filter. Other types of filter could be utilized.

In an example, the determination of the vibration signal comprises segmentation of the frequency vibration data into a plurality of frequency sections. The determination of the plurality of spectral indicators or the plurality of spectral points comprises a determination of an energy of two or more frequency sections of the plurality of frequency sections.

Thus, for example the frequency vibration data could be segmented into 10 frequency sections and the algorithm is implemented into a low-level controller and only sections 1, 2, and 7 (for example) are utilized for energy determination.

In an example, the determining the plurality of spectral indicators or the plurality of spectral points comprises determining an energy of each frequency section of the plurality of frequency sections.

In an example, the determination of the plurality of spectral indicators or the plurality of spectral points comprises extraction of an amplitude and/or frequency of each local maximum and/or each local minimum of at least one local maximum and/or at least one local minimum of the vibration signal.

In an example, the analysis of the plurality of spectral indicators or the plurality of spectral points comprises analysis of the plurality of spectral indicators or the plurality of spectral points by a machine learning algorithm. The machine learning algorithm was trained on a plurality of reference spectral indicators or a plurality of reference spectral points of a moveable contact with respect to a fixed contact over at least a portion of a plurality of reference opening operations of at least one reference circuit breaker determined from a plurality of reference temporal vibration data over the at least a portion of the plurality of the reference opening operations of the at least one reference circuit breaker. The at least a portion of the reference opening operations comprised: movement of a moveable contact away from a fixed contact.

In an example, the trained machine learning algorithm comprises a Bayesian model or a Neural Network.

In an example, the analysis of the plurality of spectral indicators or the plurality of spectral points comprises a comparison of the plurality of spectral indicators or the plurality of spectral points with a plurality of reference spectral indicators or a plurality of reference spectral points of a moveable contact with respect to a fixed contact over at least a portion of a plurality of reference opening operations of at least one reference circuit breaker determined from a plurality of reference temporal vibration data over the at least a portion of the plurality of the reference opening operations of the at least one reference circuit breaker. The at least a portion of the reference opening operations comprised: movement of a moveable contact away from a fixed contact.

In an example, the plurality of reference spectral indicators or the plurality of reference spectral points are stored in a database.

In an example, the database is comprised within the processing unit.

In an example, the database is separate to the processing unit.

In an example, the comparison comprises: utilization of distance measurements between the plurality of spectral indicators or the plurality of spectral points with a plurality of reference spectral indicators or a plurality of reference spectral points and/or the comparison comprises: utilization of a system identification analysis.

In an example the system identification analysis comprises Principle Component Analysis.

In an example the system identification analysis comprises utilization of one or more autoencoders.

Other system identification analysis techniques can be utilized.

In an example, the at least a portion of the opening operation of the circuit breaker is the same as the at least a portion of the plurality of the reference opening operations of the at least one reference circuit breaker.

In an example, the at least a portion of the opening operation of the circuit breaker comprises initiation of the opening operation and/or latch release, and the at least a portion of the plurality of the reference opening operations of the at least one reference circuit breaker comprised initiation of the opening operation and/or latch release.

In an example, the at least a portion of the opening operation of the circuit breaker comprises separation of the moveable contact from the fixed contact and/or stop of movement of the moveable contact, and the at least a portion of the plurality of the reference opening operations of the at least one reference circuit breaker comprised separation of the moveable contact from the fixed contact and/or stop of movement of the moveable contact.

In an example, at least some of the plurality of temporal vibration data over the at least a portion of the plurality of the reference opening operations of the at least one reference circuit breaker was synthetically generated by a circuit breaker vibration data generator.

In an example, the processing unit is configured to determine a prognostication result comprising utilization of the plurality of spectral indicators or the plurality of spectral points.

In an example, determination of the prognostication result comprises self-calibration, characterization and thresholding.

In an example, the prognostication result comprises an estimated remaining lifetime of the circuit breaker.

In a third aspect, there is provided a circuit breaker monitoring method, comprising:
- acquiring, by a vibration sensor mounted to a circuit breaker, temporal vibration data over at least a portion of a closing operation of the circuit breaker, wherein the at least a portion of the closing operation comprises: movement of a moveable contact towards a fixed contact;
- providing, by the vibration sensor, the temporal vibration data to a processing unit;
- converting, by the processing unit, the temporal vibration data into frequency vibration data;
- determining, by the processing unit, a vibration signal based on the frequency vibration data;
- determining, by the processing unit, a plurality of spectral indicators or a plurality of spectral points based on the vibration signal;
- determining, by the processing unit, an indication of operational functionality of the circuit breaker, wherein the determination comprises analyzing the plurality of spectral indicators or the plurality of spectral points; and
- outputting, by an output unit, information relating to the indication of operational functionality of the circuit breaker.

In an example, the vibration sensor comprises an accelerometer, a laser vibrometer, a gyroscope, or a microphone.

In an example, the conversion of the temporal vibration data into the frequency vibration data comprises utilization of a mathematical transformation.

In an example, the converting the temporal vibration data into the frequency vibration data comprises utilizing a Fourier transform, Hilbert transform, or Wavelet transform.

In an example, the determining the vibration signal comprises applying one or more of: a moving average filter, a moving median filter, a low pass filter, a high pass filter, a bandpass filter, a wavelet denoising filter. Other types of filter could be utilized.

In an example, the determining the vibration signal comprises segmenting the frequency vibration data into a plurality of frequency sections; and the determining the plurality of spectral indicators or the plurality of spectral points comprises determining an energy of two or more frequency sections of the plurality of frequency sections.

Thus, for example the frequency vibration data could be segmented into 10 frequency sections and the algorithm is implemented into a low-level controller and only sections 1, 2, and 7 (for example) are utilized for energy determination.

In an example, the determining the plurality of spectral indicators or the plurality of spectral points comprises determining an energy of each frequency section of the plurality of frequency sections.

In an example, the determining the plurality of spectral indicators or the plurality of spectral points comprises extracting an amplitude and/or frequency of each local maximum and/or each local minimum of at least one local maximum and/or at least one local minimum of the vibration signal.

In an example, the analyzing the plurality of spectral indicators or the plurality of spectral points comprises analyzing the plurality of spectral indicators or the plurality of spectral points by a machine learning algorithm. The machine learning algorithm was trained on a plurality of reference spectral indicators or a plurality of reference spectral points of a moveable contact with respect to a fixed contact over at least a portion of a plurality of reference closing operations of at least one reference circuit breaker determined from a plurality of reference temporal vibration data over the at least a portion of the plurality of the reference closing operations of the at least one reference circuit breaker. The at least a portion of the reference closing operations comprised: movement of a moveable contact towards a fixed contact.

In an example, the trained machine learning algorithm comprises a Bayesian model or a Neural Network.

In an example, the analyzing the plurality of spectral indicators or the plurality of spectral points comprises comparing the plurality of spectral indicators or the plurality of spectral points with a plurality of reference spectral indicators or a plurality of reference spectral points of a moveable contact with respect to a fixed contact over at least a portion of a plurality of reference closing operations of at least one reference circuit breaker determined from a plurality of reference temporal vibration data over the at least a portion of the plurality of the reference closing operations of the at least one reference circuit breaker. The at least a portion of the reference closing operations comprised: movement of a moveable contact towards a fixed contact.

In an example, the plurality of reference spectral indicators or the plurality of reference spectral points are stored in a database.

In an example, the database is comprised within the processing unit.

In an example, the database is separate to the processing unit.

In an example, the comparing comprises: utilizing distance measurements between the plurality of spectral indicators or the plurality of spectral points with a plurality of reference spectral indicators or a plurality of reference spectral points and/or the comparison comprises: utilization of a system identification analysis.

In an example the system identification analysis comprises Principle Component Analysis.

In an example the system identification analysis comprises utilization of one or more autoencoders.

Other system identification analysis techniques can be utilized.

In an example, the at least a portion of the closing operation of the circuit breaker is the same as the at least a portion of the plurality of the reference closing operations of the at least one reference circuit breaker.

In an example, the at least a portion of the closing operation of the circuit breaker comprises initiation of the closing operation and/or latch release, and the at least a portion of the plurality of the reference closing operations of the at least one reference circuit breaker comprised initiation of the closing operation and/or latch release.

In an example, the at least a portion of the closing operation of the circuit breaker comprises contact touch of the moveable contact with the fixed contact and/or stop of movement of the moveable contact, and the at least a portion of the plurality of the reference closing operations of the at least one reference circuit breaker comprised contact touch of the moveable contact with the fixed contact and/or stop of movement of the moveable contact.

In an example, at least some of the plurality of temporal vibration data over the at least a portion of the plurality of the reference closing operations of the at least one reference circuit breaker was synthetically generated by a circuit breaker vibration data generator.

In an example, the method comprises determining, by processing unit, a prognostication result comprising utilizing the plurality of spectral indicators or the plurality of spectral points.

In an example, determining the prognostication result comprises self-calibration, characterization and thresholding.

In an example, the prognostication result comprises an estimated remaining lifetime of the circuit breaker.

In a fourth aspect, there is provided a circuit breaker monitoring method, comprising:
- acquiring, by a vibration sensor mounted to a circuit breaker, temporal vibration data over at least a portion of an opening operation of the circuit breaker, wherein the at least a portion of the opening operation comprises: movement of a moveable contact away from a fixed contact;
- providing, by the vibration sensor, the temporal vibration data to a processing unit;
- converting, by the processing unit, the temporal vibration data into frequency vibration data;
- determining, by the processing unit, a vibration signal based on the frequency vibration data;
- determining, by the processing unit, a plurality of spectral indicators or a plurality of spectral points based on the vibration signal;
- determining, by the processing unit, an indication of operational functionality of the circuit breaker, wherein the determining comprises analyzing the plurality of spectral indicators or the plurality of spectral points; and
- outputting, by an output unit, information relating to the indication of operational functionality of the circuit breaker.

In an example, the vibration sensor comprises an accelerometer, a laser vibrometer, a gyroscope, or a microphone.

In an example, the conversion of the temporal vibration data into the frequency vibration data comprises utilization of a mathematical transformation.

In an example, the converting the temporal vibration data into the frequency vibration data comprises utilizing a Fourier transform, Hilbert transform, or Wavelet transform.

In an example, the determining the vibration signal comprises applying one or more of: a moving average filter, a moving median filter, a low pass filter, a high pass filter, a bandpass filter, a wavelet denoising filter. Other types of filter could be utilized.

In an example, the determining the vibration signal comprises segmenting the frequency vibration data into a plurality of frequency sections; and the determining the plurality of spectral indicators or the plurality of spectral points comprises determining of an energy of each frequency section of the plurality of frequency sections.

In an example, the determining the plurality of spectral indicators or the plurality of spectral points comprises extracting an amplitude and/or frequency of each local maximum and/or each local minimum of at least one local maximum and/or at least one local minimum of the vibration signal.

In an example, the analyzing the plurality of spectral indicators or the plurality of spectral points comprises analyzing the plurality of spectral indicators or the plurality of spectral points by a machine learning algorithm. The machine learning algorithm was trained on a plurality of reference spectral indicators or a plurality of reference spectral points of a moveable contact with respect to a fixed contact over at least a portion of a plurality of reference opening operations of at least one reference circuit breaker determined from a plurality of reference temporal vibration data over the at least a portion of the plurality of the reference opening operations of the at least one reference circuit breaker. The at least a portion of the reference opening operations comprised: movement of a moveable contact away from a fixed contact.

In an example, the trained machine learning algorithm comprises a Bayesian model or a Neural Network.

In an example, the analyzing the plurality of spectral indicators or the plurality of spectral points comprises comparing the plurality of spectral indicators or the plurality of spectral points with a plurality of reference spectral indicators or a plurality of reference spectral points of a moveable contact with respect to a fixed contact over at least a portion of a plurality of reference opening operations of at least one reference circuit breaker determined from a plurality of reference temporal vibration data over the at least a portion of the plurality of the reference opening operations of the at least one reference circuit breaker. The at least a portion of the reference opening operations comprised: movement of a moveable contact away from a fixed contact.

In an example, the plurality of reference spectral indicators or the plurality of reference spectral points are stored in a database.

In an example, the database is comprised within the processing unit.

In an example, the database is separate to the processing unit.

In an example, the comparing comprises: utilizing distance measurements between the plurality of spectral indicators or the plurality of spectral points with a plurality of reference spectral indicators or a plurality of reference spectral points and/or the comparison comprises: utilization of a system identification analysis.

In an example the system identification analysis comprises Principle Component Analysis.

In an example the system identification analysis comprises utilization of one or more autoencoders.

Other system identification analysis techniques can be utilized.

In an example, the at least a portion of the opening operation of the circuit breaker is the same as the at least a portion of the plurality of the reference opening operations of the at least one reference circuit breaker.

In an example, the at least a portion of the opening operation of the circuit breaker comprises initiation of the opening operation and/or latch release, and the at least a portion of the plurality of the reference opening operations of the at least one reference circuit breaker comprised initiation of the opening operation and/or latch release.

In an example, the at least a portion of the opening operation of the circuit breaker comprises separation of the moveable contact from the fixed contact and/or stop of movement of the moveable contact, and the at least a portion of the plurality of the reference opening operations of the at least one reference circuit breaker comprised separation of the moveable contact from the fixed contact and/or stop of movement of the moveable contact.

In an example, at least some of the plurality of temporal vibration data over the at least a portion of the plurality of the reference opening operations of the at least one reference circuit breaker was synthetically generated by a circuit breaker vibration data generator.

In an example, the method comprises determining, by the processing unit, a prognostication result comprising utilizing the plurality of spectral indicators or the plurality of spectral points.

In an example, determination of the prognostication result comprises self-calibration, characterization and thresholding.

In an example, the prognostication result comprises an estimated remaining lifetime of the circuit breaker.

In a fifth aspect, there is provided a switchgear comprising a system according to the first aspect.

In a sixth aspect, there is provided a switchgear comprising a system according to the second aspect.

In a seventh aspect, there is provided a computer program element for controlling a system which when executed by a processor is configured to carry out the method according to the third aspect.

In an example, there is provided a computer readable medium having stored the computer element of the seventh aspect.

In an eighth aspect, there is provided a computer program element for controlling a system which when executed by a processor is configured to carry out the method according to the fourth aspect.

In an example, there is provided a computer readable medium having stored the computer element of the eighth aspect.

The computer program elements can for example be a software program but can also be a FPGA, a PLD or any other appropriate digital means.

The above aspects and examples will become apparent from and be elucidated with reference to the embodiments described hereinafter.

### BRIEF DESCRIPTION OF THE DRAWINGS

Exemplary embodiments will be described in the following with reference to the following drawings:
Fig. 1 shows an exemplar circuit breaker monitoring system;
Fig. 2 shows an exemplar circuit breaker monitoring method;
Fig. 3 shows an exemplar time domain signal (left) and frequency spectrum (right) from acceleration/vibration measurements for closing operation (top) and opening operation (bottom) for a circuit breaker;
Fig. 4 shows examples of averaging methods for dealing with chaotic signals with triangular filterbank (left) and moving average filter (right) for closing operation (top) and opening operation (bottom) for a circuit breaker; and
Fig. 5 shows examples of polynomial fit of frequency-based envelope (left) and detection of local maxima (right) for closing operation (top) and opening operation (bottom) for a circuit breaker;

### DETAILED DESCRIPTION OF EMBODIMENTS

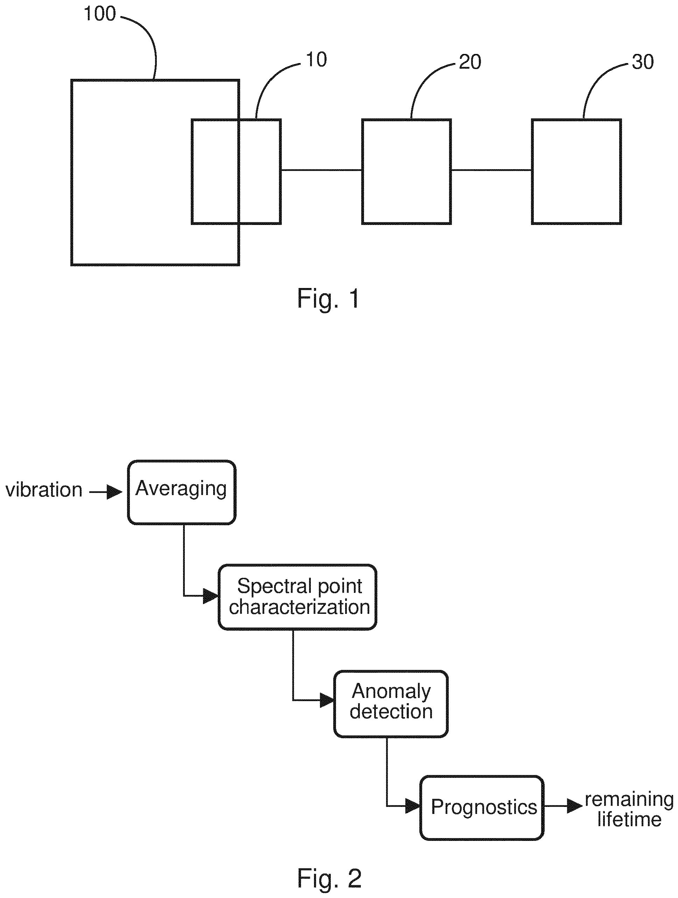

Figs. 1-5 relate to circuit breaker monitoring systems, and circuit breaker monitoring methods that can be applied to a circuit breaker of a switchgear.

Fig. 1 shows an exemplar circuit breaker monitoring system.

An exemplar circuit breaker monitoring system comprises:
- a vibration sensor 10;
- a processing unit 20; and
- an output unit 30.

The vibration sensor is configured to be mounted to a circuit breaker 100. The vibration sensor is configured to acquire temporal vibration data over at least a portion of a closing operation of the circuit breaker. The at least a portion of the closing operation comprises: movement of a moveable contact towards a fixed contact. The vibration sensor is configured to provide the temporal vibration data to the processing unit. The processing unit is configured to convert the temporal vibration data into frequency vibration data. The processing unit is configured to determine a vibration signal based on the frequency vibration data. The processing unit is configured to determine a plurality of spectral indicators or a plurality of spectral points based on the vibration signal. The processing unit is configured to determine an indication of operational functionality of the circuit breaker, the determination comprising analysis of the plurality of spectral indicators or the plurality of spectral points. The output unit is configured to output information relating to the indication of operational functionality of the circuit breaker.

In an example, the vibration sensor comprises an accelerometer, a laser vibrometer, a gyroscope, or a microphone.

In an example, the conversion of the temporal vibration data into the frequency vibration data comprises utilization of a mathematical transformation.

In an example, the conversion of the temporal vibration data into the frequency vibration data comprises utilization of a Fourier transform, Hilbert transform, or Wavelet transform.

In an example, the determination of the vibration signal comprises application of one or more of: a moving average filter, a moving median filter, a low pass filter, a high pass filter, a bandpass filter, a wavelet denoising filter. Other types of filter could be utilized.

In an example, the determination of the vibration signal comprises segmentation of the frequency vibration data into a plurality of frequency sections. The determination of the plurality of spectral indicators or the plurality of spectral points comprises a determination of an energy of two or more frequency sections of the plurality of frequency sections.

Thus, for example the frequency vibration data could be segmented into 10 frequency sections and the algorithm is implemented into a low-level controller and only sections 1, 2, and 7 (for example) are utilized for energy determination.

In an example, the determining the plurality of spectral indicators or the plurality of spectral points comprises determining an energy of each frequency section of the plurality of frequency sections.

In an example, the determination of the plurality of spectral indicators or the plurality of spectral points comprises extraction of an amplitude and/or frequency of each local maximum and/or each local minimum of at least one local maximum and/or at least one local minimum of the vibration signal.

In an example, the analysis of the plurality of spectral indicators or the plurality of spectral points comprises analysis of the plurality of spectral indicators or the plurality of spectral points by a machine learning algorithm. The machine learning algorithm was trained on a plurality of reference spectral indicators or a plurality of reference spectral points of a moveable contact with respect to a fixed contact over at least a portion of a plurality of reference closing operations of at least one reference circuit breaker determined from a plurality of reference temporal vibration data over the at least a portion of the plurality of the reference closing operations of the at least one reference circuit breaker. The at least a portion of the reference closing operations comprised: movement of a moveable contact towards a fixed contact.

In an example, the trained machine learning algorithm comprises a Bayesian model or a Neural Network.

In an example, the analysis of the plurality of spectral indicators or the plurality of spectral points comprises a comparison of the plurality of spectral indicators or the plurality of spectral points with a plurality of reference spectral indicators or a plurality of reference spectral points of a moveable contact with respect to a fixed contact over at least a portion of a plurality of reference closing operations of at least one reference circuit breaker determined from a plurality of reference temporal vibration data over the at least a portion of the plurality of the reference closing operations of the at least one reference circuit breaker. The at least a portion of the reference closing operations comprised: movement of a moveable contact towards a fixed contact.

In an example, the plurality of reference spectral indicators or the plurality of reference spectral points are stored in a database.

In an example, the database is comprised within the processing unit.

In an example, the database is separate to the processing unit.

In an example, the comparison comprises: utilization of distance measurements between the plurality of spectral indicators or the plurality of spectral points with a plurality of reference spectral indicators or a plurality of reference spectral points and/or the comparison comprises: utilization of a system identification analysis.

In an example the system identification analysis comprises Principle Component Analysis.

In an example the system identification analysis comprises utilization of one or more autoencoders.

Other system identification analysis techniques can be utilized.

In an example, the at least a portion of the closing operation of the circuit breaker is the same as the at least a portion of the plurality of the reference closing operations of the at least one reference circuit breaker.

In an example, the at least a portion of the closing operation of the circuit breaker comprises initiation of the closing operation and/or latch release, and the at least a portion of the plurality of the reference closing operations of the at least one reference circuit breaker comprised initiation of the closing operation and/or latch release.

In an example, the at least a portion of the closing operation of the circuit breaker comprises contact touch of the moveable contact with the fixed contact and/or stop of movement of the moveable contact. The at least a portion of the plurality of the reference closing operations of the at least one reference circuit breaker comprised contact touch of the moveable contact with the fixed contact and/or stop of movement of the moveable contact.

In an example, at least some of the plurality of temporal vibration data over the at least a portion of the plurality of the reference closing operations of the at least one reference circuit breaker was synthetically generated by a circuit breaker vibration data generator.

In an example, the processing unit is configured to determine a prognostication result comprising utilization of the plurality of spectral indicators or the plurality of spectral points.

In an example, determination of the prognostication result comprises self-calibration, characterization and thresholding.

In an example, the prognostication result comprises an estimated remaining lifetime of the circuit breaker.

An exemplar circuit breaker monitoring system comprises:
- a vibration sensor 10;
- a processing unit 20; and
- an output unit 30.

The vibration sensor is configured to be mounted to a circuit breaker 100. The vibration sensor is configured to acquire temporal vibration data over at least a portion of an opening operation of the circuit breaker. The at least a portion of the opening operation comprises: movement of a moveable contact away from a fixed contact. The vibration sensor is configured to provide the temporal vibration data to the processing unit. The processing unit is configured to convert the temporal vibration data into frequency vibration data. The processing unit is configured to determine a vibration signal based on the frequency vibration data. The processing unit is configured to determine a plurality of spectral indicators or a plurality of spectral points based on the vibration signal. The processing unit is configured to determine an indication of operational functionality of the circuit breaker, the determination comprising analysis of the plurality of spectral indicators or the plurality of spectral points. The output unit is configured to output information relating to the indication of operational functionality of the circuit breaker.

In an example, the vibration sensor comprises an accelerometer, a laser vibrometer, a gyroscope, or a microphone.

In an example, the conversion of the temporal vibration data into the frequency vibration data comprises utilization of a mathematical transformation.

In an example, the conversion of the temporal vibration data into the frequency vibration data comprises utilization of a Fourier transform, Hilbert transform, or Wavelet transform.

In an example, the determination of the vibration signal comprises application of one or more of: a moving average filter, a moving median filter, a low pass filter, a high pass filter, a bandpass filter, a wavelet denoising filter. Other types of filter could be utilized.

In an example, the determination of the vibration signal comprises segmentation of the frequency vibration data into a plurality of frequency sections. The determination of the plurality of spectral indicators or the plurality of spectral points comprises a determination of an energy of two or more frequency sections of the plurality of frequency sections.

Thus, for example the frequency vibration data could be segmented into 10 frequency sections and the algorithm is implemented into a low-level controller and only sections 1, 2, and 7 (for example) are utilized for energy determination.

In an example, the determining the plurality of spectral indicators or the plurality of spectral points comprises determining an energy of each frequency section of the plurality of frequency sections.

In an example, the determination of the plurality of spectral indicators or the plurality of spectral points comprises extraction of an amplitude and/or frequency of each local maximum and/or each local minimum of at least one local maximum and/or at least one local minimum of the vibration signal.

In an example, the analysis of the plurality of spectral indicators or the plurality of spectral points comprises analysis of the plurality of spectral indicators or the plurality of spectral points by a machine learning algorithm. The machine learning algorithm was trained on a plurality of reference spectral indicators or a plurality of reference spectral points of a moveable contact with respect to a fixed contact over at least a portion of a plurality of reference opening operations of at least one reference circuit breaker determined from a plurality of reference temporal vibration data over the at least a portion of the plurality of the reference opening operations of the at least one reference circuit breaker. The at least a portion of the reference opening operations comprised: movement of a moveable contact away from a fixed contact.

In an example, the trained machine learning algorithm comprises a Bayesian model or a Neural Network.

In an example, the analysis of the plurality of spectral indicators or the plurality of spectral points comprises a comparison of the plurality of spectral indicators or the plurality of spectral points with a plurality of reference spectral indicators or a plurality of reference spectral points of a moveable contact with respect to a fixed contact over at least a portion of a plurality of reference opening operations of at least one reference circuit breaker determined from a plurality of reference temporal vibration data over the at least a portion of the plurality of the reference opening operations of the at least one reference circuit breaker. The at least a portion of the reference opening operations comprised: movement of a moveable contact away from a fixed contact.

In an example, the plurality of reference spectral indicators or the plurality of reference spectral points are stored in a database.

In an example, the database is comprised within the processing unit.

In an example, the database is separate to the processing unit.

In an example, the comparison comprises: utilization of distance measurements between the plurality of spectral indicators or the plurality of spectral points with a plurality of reference spectral indicators or a plurality of reference spectral points and/or the comparison comprises: utilization of a system identification analysis.

In an example the system identification analysis comprises Principle Component Analysis.

In an example the system identification analysis comprises utilization of one or more autoencoders.

Other system identification analysis techniques can be utilized.

In an example, the at least a portion of the opening operation of the circuit breaker is the same as the at least a portion of the plurality of the reference opening operations of the at least one reference circuit breaker.

In an example, the at least a portion of the opening operation of the circuit breaker comprises initiation of the opening operation and/or latch release, and the at least a portion of the plurality of the reference opening operations of the at least one reference circuit breaker comprised initiation of the opening operation and/or latch release.

In an example, the at least a portion of the opening operation of the circuit breaker comprises separation of the moveable contact from the fixed contact and/or stop of movement of the moveable contact, and the at least a portion of the plurality of the reference opening operations of the at least one reference circuit breaker comprised separation of the moveable contact from the fixed contact and/or stop of movement of the moveable contact.

In an example, at least some of the plurality of temporal vibration data over the at least a portion of the plurality of the reference opening operations of the at least one reference circuit breaker was synthetically generated by a circuit breaker vibration data generator.

In an example, the processing unit is configured to determine a prognostication result comprising utilization of the plurality of spectral indicators or the plurality of spectral points.

In an example, determination of the prognostication result comprises self-calibration, characterization and thresholding.

In an example, the prognostication result comprises an estimated remaining lifetime of the circuit breaker.

Fig. 2 shows an exemplar circuit breaker monitoring method in a detailed embodiment.

An exemplar circuit breaker monitoring method comprises:
- acquiring, by a vibration sensor mounted to a circuit breaker, temporal vibration data over at least a portion of a closing operation of the circuit breaker, wherein the at least a portion of the closing operation comprises: movement of a moveable contact towards a fixed contact;
- providing, by the vibration sensor, the temporal vibration data to a processing unit;
- converting, by the processing unit, the temporal vibration data into frequency vibration data;
- determining, by the processing unit, a vibration signal based on the frequency vibration data;
- determining, by the processing unit, a plurality of spectral indicators or a plurality of spectral points based on the vibration signal;
- determining, by the processing unit, an indication of operational functionality of the circuit breaker, wherein the determination comprises analyzing the plurality of spectral indicators or the plurality of spectral points; and
- outputting, by an output unit, information relating to the indication of operational functionality of the circuit breaker.

In an example, the vibration sensor comprises an accelerometer, a laser vibrometer, a gyroscope, or a microphone.

In an example, the conversion of the temporal vibration data into the frequency vibration data comprises utilization of a mathematical transformation.

In an example, the converting the temporal vibration data into the frequency vibration data comprises utilizing a Fourier transform, Hilbert transform, or Wavelet transform.

In an example, the determining the vibration signal comprises applying one or more of: a moving average filter, a moving median filter, a low pass filter, a high pass filter, a bandpass filter, a wavelet denoising filter. Other types of filter could be utilized.

In an example, the determining the vibration signal comprises segmenting the frequency vibration data into a plurality of frequency sections; and the determining the plurality of spectral indicators or the plurality of spectral points comprises determining an energy of two or more frequency sections of the plurality of frequency sections.

Thus, for example the frequency vibration data could be segmented into 10 frequency sections and the algorithm is implemented into a low-level controller and only sections 1, 2, and 7 (for example) are utilized for energy determination.

In an example, the determining the plurality of spectral indicators or the plurality of spectral points comprises determining an energy of each frequency section of the plurality of frequency sections.

In an example, the determining the plurality of spectral indicators or the plurality of spectral points comprises extracting an amplitude and/or frequency of each local maximum and/or each local minimum of at least one local maximum and/or at least one local minimum of the vibration signal.

In an example, the analyzing the plurality of spectral indicators or the plurality of spectral points comprises analyzing the plurality of spectral indicators or the plurality of spectral points by a machine learning algorithm. The machine learning algorithm was trained on a plurality of reference spectral indicators or a plurality of reference spectral points of a moveable contact with respect to a fixed contact over at least a portion of a plurality of reference closing operations of at least one reference circuit breaker determined from a plurality of reference temporal vibration data over the at least a portion of the plurality of the reference closing operations of the at least one reference circuit breaker. The at least a portion of the reference closing operations comprised: movement of a moveable contact towards a fixed contact.

In an example, the trained machine learning algorithm comprises a Bayesian model or a Neural Network.

In an example, the analyzing the plurality of spectral indicators or the plurality of spectral points comprises comparing the plurality of spectral indicators or the plurality of spectral points with a plurality of reference spectral indicators or a plurality of reference spectral points of a moveable contact with respect to a fixed contact over at least a portion of a plurality of reference closing operations of at least one reference circuit breaker determined from a plurality of reference temporal vibration data over the at least a portion of the plurality of the reference closing operations of the at least one reference circuit breaker. The at least a portion of the reference closing operations comprised: movement of a moveable contact towards a fixed contact.

In an example, the plurality of reference spectral indicators or the plurality of reference spectral points are stored in a database.

In an example, the database is comprised within the processing unit.

In an example, the database is separate to the processing unit.

In an example, the comparing comprises: utilizing distance measurements between the plurality of spectral indicators or the plurality of spectral points with a plurality of reference spectral indicators or a plurality of reference spectral points and/or the comparison comprises: utilization of a system identification analysis.

In an example the system identification analysis comprises Principle Component Analysis.

In an example the system identification analysis comprises utilization of one or more autoencoders.

Other system identification analysis techniques can be utilized.

In an example, the at least a portion of the closing operation of the circuit breaker is the same as the at least a portion of the plurality of the reference closing operations of the at least one reference circuit breaker.

In an example, the at least a portion of the closing operation of the circuit breaker comprises initiation of the closing operation and/or latch release, and the at least a portion of the plurality of the reference closing operations of the at least one reference circuit breaker comprised initiation of the closing operation and/or latch release.

In an example, the at least a portion of the closing operation of the circuit breaker comprises contact touch of the moveable contact with the fixed contact and/or stop of movement of the moveable contact, and the at least a portion of the plurality of the reference closing operations of the at least one reference circuit breaker comprised contact touch of the moveable contact with the fixed contact and/or stop of movement of the moveable contact.

In an example, at least some of the plurality of temporal vibration data over the at least a portion of the plurality of the reference closing operations of the at least one reference circuit breaker was synthetically generated by a circuit breaker vibration data generator.

In an example, the method comprises determining, by processing unit, a prognostication result comprising utilizing the plurality of spectral indicators or the plurality of spectral points.

In an example, determining the prognostication result comprises self-calibration, characterization and thresholding.

In an example, the prognostication result comprises an estimated remaining lifetime of the circuit breaker.

An exemplar circuit breaker monitoring method comprises:
- acquiring, by a vibration sensor mounted to a circuit breaker, temporal vibration data over at least a portion of an opening operation of the circuit breaker, wherein the at least a portion of the opening operation comprises: movement of a moveable contact away from a fixed contact;
- providing, by the vibration sensor, the temporal vibration data to a processing unit;
- converting, by the processing unit, the temporal vibration data into frequency vibration data;
- determining, by the processing unit, a vibration signal based on the frequency vibration data;
- determining, by the processing unit, a plurality of spectral indicators or a plurality of spectral points based on the vibration signal;
- determining, by the processing unit, an indication of operational functionality of the circuit breaker, wherein the determining comprises analyzing the plurality of spectral indicators or the plurality of spectral points; and
- outputting, by an output unit, information relating to the indication of operational functionality of the circuit breaker.

In an example, the vibration sensor comprises an accelerometer, a laser vibrometer, a gyroscope, or a microphone.

In an example, the conversion of the temporal vibration data into the frequency vibration data comprises utilization of a mathematical transformation.

In an example, the converting the temporal vibration data into the frequency vibration data comprises utilizing a Fourier transform, Hilbert transform, or Wavelet transform.

In an example, the determining the vibration signal comprises applying one or more of: a moving average filter, a moving median filter, a low pass filter, a high pass filter, a bandpass filter, a wavelet denoising filter. Other types of filter could be utilized.

In an example, the determining the vibration signal comprises segmenting the frequency vibration data into a plurality of frequency sections; and the determining the plurality of spectral indicators or the plurality of spectral points comprises determining of an energy of two or more frequency sections of the plurality of frequency sections.

Thus, for example the frequency vibration data could be segmented into 10 frequency sections and the algorithm is implemented into a low-level controller and only sections 1, 2, and 7 (for example) are utilized for energy determination.

In an example, the determining the plurality of spectral indicators or the plurality of spectral points comprises determining an energy of each frequency section of the plurality of frequency sections.

In an example, the determining the plurality of spectral indicators or the plurality of spectral points comprises extracting an amplitude and/or frequency of each local maximum and/or each local minimum of at least one local maximum and/or at least one local minimum of the vibration signal.

In an example, the analyzing the plurality of spectral indicators or the plurality of spectral points comprises analyzing the plurality of spectral indicators or the plurality of spectral points by a machine learning algorithm. The machine learning algorithm was trained on a plurality of reference spectral indicators or a plurality of reference spectral points of a moveable contact with respect to a fixed contact over at least a portion of a plurality of reference opening operations of at least one reference circuit breaker determined from a plurality of reference temporal vibration data over the at least a portion of the plurality of the reference opening operations of the at least one reference circuit breaker. The at least a portion of the reference opening operations comprised: movement of a moveable contact away from a fixed contact.

In an example, the trained machine learning algorithm comprises a Bayesian model or a Neural Network.

In an example, the analyzing the plurality of spectral indicators or the plurality of spectral points comprises comparing the plurality of spectral indicators or the plurality of spectral points with a plurality of reference spectral indicators or a plurality of reference spectral points of a moveable contact with respect to a fixed contact over at least a portion of a plurality of reference opening operations of at least one reference circuit breaker determined from a plurality of reference temporal vibration data over the at least a portion of the plurality of the reference opening operations of the at least one reference circuit breaker. The at least a portion of the reference opening operations comprised: movement of a moveable contact away from a fixed contact.

In an example, the plurality of reference spectral indicators or the plurality of reference spectral points are stored in a database.

In an example, the database is comprised within the processing unit.

In an example, the database is separate to the processing unit.

In an example, the comparing comprises: utilizing distance measurements between the plurality of spectral indicators or the plurality of spectral points with a plurality of reference spectral indicators or a plurality of reference spectral points and/or the comparison comprises: utilization of a system identification analysis.

In an example the system identification analysis comprises Principle Component Analysis.

In an example the system identification analysis comprises utilization of one or more autoencoders.

Other system identification analysis techniques can be utilized.

In an example, the at least a portion of the opening operation of the circuit breaker is the same as the at least a portion of the plurality of the reference opening operations of the at least one reference circuit breaker.

In an example, the at least a portion of the opening operation of the circuit breaker comprises initiation of the opening operation and/or latch release, and the at least a portion of the plurality of the reference opening operations of the at least one reference circuit breaker comprised initiation of the opening operation and/or latch release.

In an example, the at least a portion of the opening operation of the circuit breaker comprises separation of the moveable contact from the fixed contact and/or stop of movement of the moveable contact, and the at least a portion of the plurality of the reference opening operations of the at least one reference circuit breaker comprised separation of the moveable contact from the fixed contact and/or stop of movement of the moveable contact.

In an example, at least some of the plurality of temporal vibration data over the at least a portion of the plurality of the reference opening operations of the at least one reference circuit breaker was synthetically generated by a circuit breaker vibration data generator.

In an example, the method comprises determining, by the processing unit, a prognostication result comprising utilizing the plurality of spectral indicators or the plurality of spectral points.

In an example, determination of the prognostication result comprises self-calibration, characterization and thresholding.

In an example, the prognostication result comprises an estimated remaining lifetime of the circuit breaker.

In a fifth aspect, there is provided a switchgear comprising a system according to the first aspect.

In a sixth aspect, there is provided a switchgear comprising a system according to the second aspect.

Thus, the inventors realized that although frequency analysis of vibration signal has been carried out in certain situations (see: Q. Yang, J. Ruan, Z. Zhuang and D. Huang (2020). Chaotic analysis and feature extraction of vibration signals from power circuit breakers. IEEE Transactions on Power Delivery, vol. 35, no. 3, pp. 1124-1135), because typical medium-voltage circuit breakers have an extremely short operation time of less than 50 milliseconds, the frequency analysis of vibration signal is much more challenging compared to these other applications.

Also, typical medium-voltage circuit breakers have an extremely short operation time less than 50 milliseconds that makes the frequency analysis of vibration signal more challenging compared to other applications.

The new development was made to enable frequency analysis of the vibration signal from a circuit breaker.

Thus, in addition to time-based methods, the inventors realized that frequency-based methods could be used to characterize the health of the circuit breaker as an overall system, if certain issues were overcome.

Frequency-based features have been developed in many applications, i.e., structural health monitoring of civil structures (See: Gharehbaghi, V. R. et al. (2021). A critical review on structural health monitoring: Definitions, methods, and perspectives. Archives of Computational Methods in Engineering, pp. 1-27; and Yang, Y., Zhang, Y., & Tan, X. (2021). Review on vibration-based structural health monitoring techniques and technical codes. Symmetry, 13(11)) and condition monitoring of rotating machinery (see: Tiboni, M., Remino, C., Bussola, R. and Amici, C. (2022). A review on vibration-based condition monitoring of rotating machinery. Applied Sciences, 12(3), p.972; and Soto-Ocampo, C. R., Mera, J. M., Cano-Moreno, J. D., & Garcia-Bernardo, J. L. (2020). Low-cost, high-frequency, data acquisition system for condition monitoring of rotating machinery through vibration analysis-case study. Sensors, 20(12), 3493). Methods mainly include monitoring of eigenfrequencies and modes, e.g., natural frequency methods, mode-shape based damage detection, spectral difference and correlation spectra. Also, alternative decomposition methods, such as adaptive chirp mode decomposition (See: aYang, Q., Ruan, J., & Zhuang, Z. (2020). Fault diagnosis of circuit breakers based on time-frequency and chaotic vibration analysis. IET Generation, Transmission & Distribution, 14(7), 1214-1221) and related methods have been used.

However, vibration measurements on circuit breaker measurements result in nonlinear and non-stationary signals, i.e., *chaotic* signals over an extremely short duration in the range of milliseconds. In consequence, frequency spectra of these signals do not exhibit clear eigenfrequencies and do not allow for applying standard frequency-based methods.

The new development made by the inventors provides for robust, frequency-based features as an extension to existing time-based monitoring methods for medium voltage circuit breakers (See: Q. Yang, J. Ruan, Z. Zhuang and D. Huang (2020). Chaotic analysis and feature extraction of vibration signals from power circuit breakers. IEEE Transactions on Power Delivery, vol. 35, no. 3, pp. 1124-1135; and Soto-Ocampo, C. R., Mera, J. M., Cano-Moreno, J. D., & Garcia-Bernardo, J. L. (2020). Low-cost, high-frequency, data acquisition system for condition monitoring of rotating machinery through vibration analysis-case study. Sensors, 20(12), 3493). The new development enables the signal properties of vibration signals from circuit breakers to be interrogated and is valuable for monitoring / assessing the current breaker health as well as the remaining useful lifetime / prognostics of a circuit breaker.

The new development provides frequency-based features which are used to extract monitoring information from vibration measurements on the housing of a circuit breaker. The vibration characteristics of the circuit breaker can be treated in effect as the response of an overall system, which includes valuable information about the individual components. Since the overall system is of nonlinear nature and shows several vibro-impact phenomena for the non-smooth/non-stationary system during a switching operation, measured vibration signals mainly reveal chaotic behavior for the circuit breaker. Thus, the new development is a technique based on spectral point characterization that is used to extract the frequency characteristics from the chaotic spectrum of the circuit breaker in a robust manner. Anomaly detection is applied to detect changes in frequency characteristics over time and number of operations, respectively. Prognostics methods can then be applied to evaluate and assess the severeness of deviations.

The frequency-based monitoring technique is extracting robust features from chaotic signals as measured by vibration sensors (e.g., accelerometers, laser vibrometer, gyroscopes, microphones). The technique can be applied to measurements from several positions on/outside and inside the housing of the circuit breaker - either as retrofit or in-built solution. Also, the measurement direction includes a minimum of one direction but can be extended to dual-axis and triaxial sensors. While the technique works already for a single sensor at a single sensor position, an extension to several sensor positions and / or directions can improve sensitivity and robustness.

The new technique in summary of specific embodiments includes:
1. Robustness is increased by averaging the spectra, and respectively denoising.
2. Prominent spectral points are characterized for example from averaged spectra. Methods include but are not limited to energy features, e.g., root-mean-square of windowed filterbank, etc.
3. Anomaly detection is enabled by using for example a distance measure between new samples and a reference period and / or reference circuit breaker measurements.
4. Lifetime prognostics can be provided by either self-calibration plus thresholds, or by Bayesian modelling of breaker characteristics and anomalies.

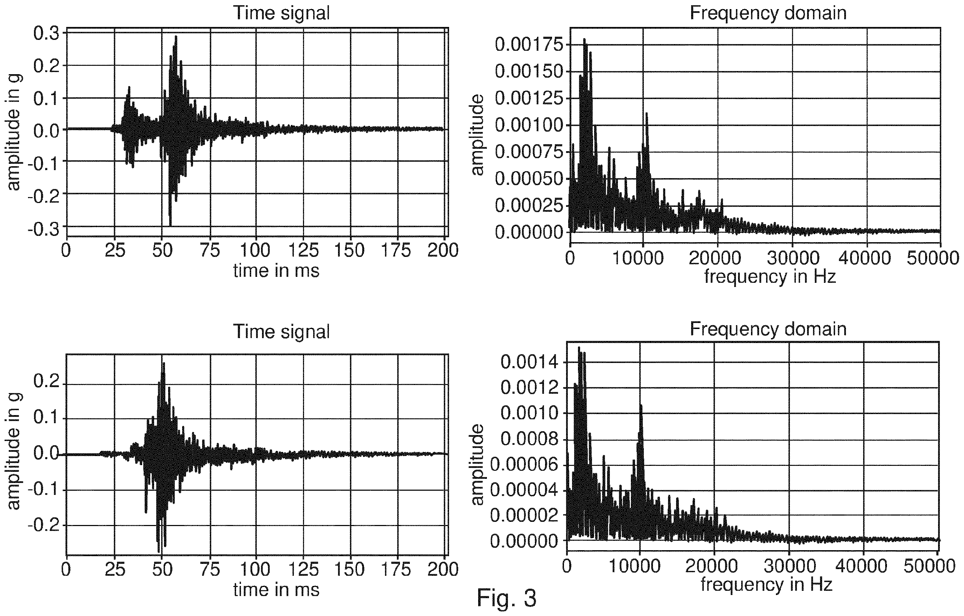

The following relates to detailed embodiments, where reference is made to Figs. 3-5.

A Fourier transform of the measured vibration signal is performed to **transform a temporal vibration signal into the frequency domain** (see Fig. 3). The following processing steps are explained in detail in the following. It is to be noted that a Fourier transform is used as an example of a suitable mathematical transformation, and that a Hilbert transform, or a Wavelet transform could be utilized for example.

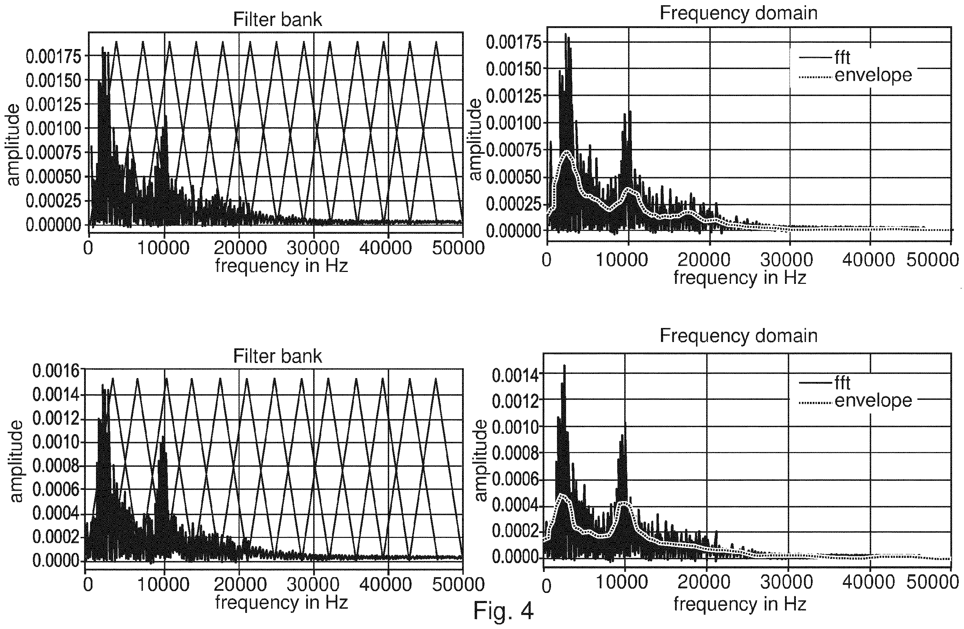

**Averaging:** Averaging methods are applied to the chaotic measurement signals to increase robustness, e.g., moving average or moving median filtering, denoising methods such as lowpass filtering, median averaging, Wavelet denoising etc. In addition, segmentation can be used such as applying a filterbank to split the signal into sections. Also, additional filtering methods (e.g., highpass filtering/bandpass filtering) can be added to characterize the signal. Parameters are adapted so that the characteristics of the chaotic signal are maintained while robustness is sufficiently increased. See Fig. 4 for two examples of filterbank segmentation (left) and envelope calculation by moving averaging filter (right).

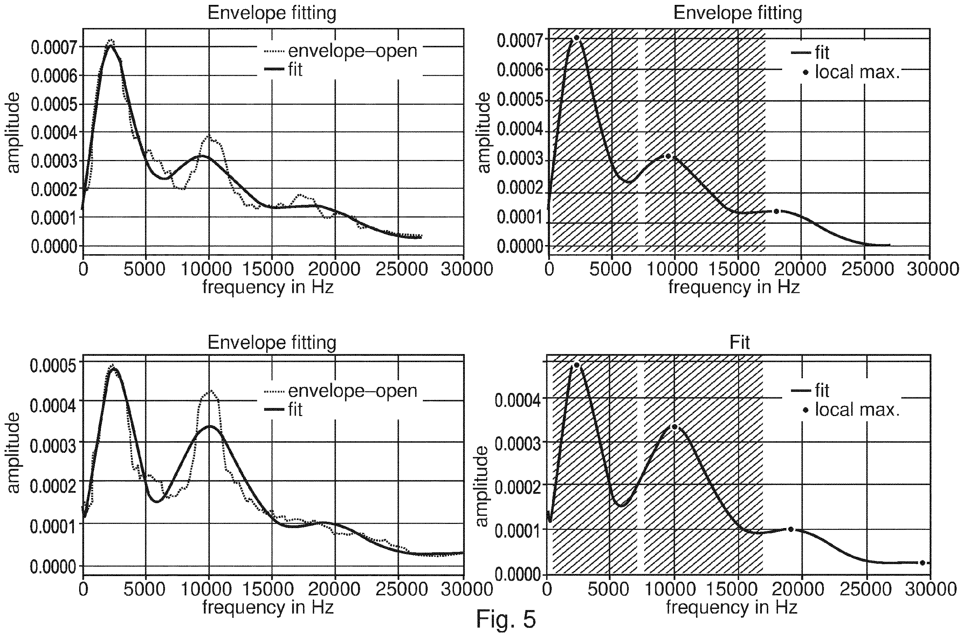

**Spectral point characterization:** The signal is characterized by specific points along the spectrum. A first method is to use the root-mean-square to extract the energy of each segment of the spectrum, see Fig. 5 (left). A second method is used to extract amplitude and/or frequency of local maxima along the spectrum based on curve fitting (e.g., polynomial fitting) as averaging method, see Fig. 5 (right).

**Anomaly detection:** Spectral points are then used for anomaly detection. Different options include:
1) Distance measures, e.g., linear distance, distance measures based on standard deviations and covariance such as Mahalanobis distance [See for example: De Maesschalck, R., Jouan-Rimbaud, D., & Massart, D. L. (2000). The mahalanobis distance. Chemometrics and intelligent laboratory systems, 50(1), 1-18.]. Thresholds are used to trigger an anomaly based on absolute or relative methods.
2) Anomaly detection methods such as Principal Component Analysis (PCA) [See for example: Bro, R., & Smilde, A. K. (2014). Principal component analysis. Analytical methods, 6(9), 2812-2831.] which treat the problem as a system identification problem.
3) Statistical methods such as Bayesian models or neural networks.

**Prognostics:** For circuit breakers without reference data set, prognostics can be done by using self-calibration, characterization and thresholding. Circuit breakers with large reference data sets, statistical modelling (e.g., Bayesian modelling) can be applied.

It is to be noted that the prognostic step is a follow-on from the transformation into the frequency domain, averaging, spectral point characterization, and anomaly detection that are enough to determine if a circuit breaker has a problem. The prognostic step then enables a remaining lifetime, for example of the circuit breaker, to be predicted (See Fig. 2).

If multiple sensor positions and/or locations are used, averaging and spectral point characterization can be done per measurement. Anomaly detection and / or prognostics can be processed either per measurement or by using sensor fusion of measurements from different sensor positions and/or directions.

Benefits of the new development includes the following:
- Robust features to detect anomalies in the properties of the breaker, e.g., degradation, damage.
- Valuable extension to existing time-based methods to detect different types of faults reliably.
- Lifetime prognostics are suited for circuit breakers with and without a reference data set.

In addition, the general benefits of the new development include an improved method to provide safety feedback to the operator, prevention of failure and enabling to schedule maintenance timely in advance. Resulting frequency-based features and prognostics results can either be used in an isolated manner, or can be used in addition to existing time-based methods i.e. See: Q. Yang, J. Ruan, Z. Zhuang and D. Huang (2020). Chaotic analysis and feature extraction of vibration signals from power circuit breakers. IEEE Transactions on Power Delivery, vol. 35, no. 3, pp. 1124-1135, and Soto-Ocampo, C. R., Mera, J. M., Cano-Moreno, J. D., & Garcia-Bernardo, J. L. (2020). Low-cost, high-frequency, data acquisition system for condition monitoring of rotating machinery through vibration analysis-case study. Sensors, 20(12), 3493, to increase robustness and sensitivity for different fault types / failure modes.

In another exemplary embodiment, a computer program or computer program element is provided that is characterized by being configured to execute the method steps of the method according to one of the preceding embodiments, on an appropriate processor or system.

The computer program element might therefore be stored on a computer unit, which might also be part of an embodiment. This computing unit may be configured to perform or induce performing of the steps of the method described above. Moreover, it may be configured to operate the components of the above described system. The computing unit can be configured to operate automatically and/or to execute the orders of a user. A computer program may be loaded into a working memory of a data processor. The data processor may thus be equipped to carry out the method according to one of the preceding embodiments.

This exemplary embodiment of the invention covers both, a computer program that right from the beginning uses the invention and computer program that by means of an update turns an existing program into a program that uses the invention.

Further on, the computer program element might be able to provide all necessary steps to fulfill the procedure of an exemplary embodiment of the method as described above.

According to a further exemplary embodiment of the present invention, a computer readable medium, such as a CD-ROM, USB stick or the like, is presented wherein the computer readable medium has a computer program element stored on it which computer program element is described by the preceding section.

A computer program may be stored and/or distributed on a suitable medium, such as an optical storage medium or a solid state medium supplied together with or as part of other hardware, but may also be distributed in other forms, such as via the internet or other wired or wireless telecommunication systems.

However, the computer program may also be presented over a network like the World Wide Web and can be downloaded into the working memory of a data processor from such a network. According to a further exemplary embodiment of the present invention, a medium for making a computer program element available for downloading is provided, which computer program element is arranged to perform a method according to one of the previously described embodiments of the invention.

## Claims

1. A circuit breaker monitoring system, comprising:
- a vibration sensor (10);
- a processing unit (20); and
- an output unit (30);
wherein the vibration sensor is configured to be mounted to a circuit breaker (100);
wherein the vibration sensor is configured to acquire temporal vibration data over at least a portion of a closing operation of the circuit breaker, wherein the at least a portion of the closing operation comprises: movement of a moveable contact towards a fixed contact;
wherein the vibration sensor is configured to provide the temporal vibration data to the processing unit;
wherein the processing unit is configured to convert the temporal vibration data into frequency vibration data;
wherein the processing unit is configured to determine a vibration signal based on the frequency vibration data;
wherein the processing unit is configured to determine a plurality of spectral indicators or a plurality of spectral points based on the vibration signal;
wherein the processing unit is configured to determine an indication of operational functionality of the circuit breaker, wherein the determination comprises analysis of the plurality of spectral indicators or the plurality of spectral points; and
wherein the output unit is configured to output information relating to the indication of operational functionality of the circuit breaker.

2. System according to claim 1, wherein the determination of the vibration signal comprises application of one or more of: a moving average filter, a moving median filter, a low pass filter, a high pass filter, a bandpass filter, a wavelet denoising filter.

3. System according to any of claims 1-2, wherein the determination of the vibration signal comprises segmentation of the frequency vibration data into a plurality of frequency sections; and wherein the determination of the plurality of spectral indicators or the plurality of spectral points comprises a determination of an energy of two or more frequency sections of the plurality of frequency sections.

4. System according to any of claims 1-2, wherein the determination of the plurality of spectral indicators or the plurality of spectral points comprises extraction of an amplitude and/or frequency of each local maximum and/or each local minimum of at least one local maximum and/or at least one local minimum of the vibration signal.

5. System according to any of claims 1-4, wherein the analysis of the plurality of spectral indicators or the plurality of spectral points comprises analysis of the plurality of spectral indicators or the plurality of spectral points by a machine learning algorithm, and wherein the machine learning algorithm was trained on a plurality of reference spectral indicators or a plurality of reference spectral points of a moveable contact with respect to a fixed contact over at least a portion of a plurality of reference closing operations of at least one reference circuit breaker determined from a plurality of reference temporal vibration data over the at least a portion of the plurality of the reference closing operations of the at least one reference circuit breaker, wherein the at least a portion of the reference closing operations comprised: movement of a moveable contact towards a fixed contact.

6. System according to any of claims 1-4, wherein the analysis of the plurality of spectral indicators or the plurality of spectral points comprises a comparison of the plurality of spectral indicators or the plurality of spectral points with a plurality of reference spectral indicators or a plurality of reference spectral points of a moveable contact with respect to a fixed contact over at least a portion of a plurality of reference closing operations of at least one reference circuit breaker determined from a plurality of reference temporal vibration data over the at least a portion of the plurality of the reference closing operations of the at least one reference circuit breaker, wherein the at least a portion of the reference closing operations comprised: movement of a moveable contact towards a fixed contact.

7. System according to claim 6, wherein the comparison comprises: utilization of distance measurements between the plurality of spectral indicators or the plurality of spectral points with a plurality of reference spectral indicators or a plurality of reference spectral points and/or wherein the comparison comprises: utilization of a system identification analysis.

8. A circuit breaker monitoring system, comprising:
- a vibration sensor (10);
- a processing unit (20); and
- an output unit (30);
wherein the vibration sensor is configured to be mounted to a circuit breaker (100);
wherein the vibration sensor is configured to acquire temporal vibration data over at least a portion of an opening operation of the circuit breaker, wherein the at least a portion of the opening operation comprises: movement of a moveable contact away from a fixed contact;
wherein the vibration sensor is configured to provide the temporal vibration data to the processing unit;
wherein the processing unit is configured to convert the temporal vibration data into frequency vibration data;
wherein the processing unit is configured to determine a vibration signal based on the frequency vibration data;
wherein the processing unit is configured to determine a plurality of spectral indicators or a plurality of spectral points based on the vibration signal;
wherein the processing unit is configured to determine an indication of operational functionality of the circuit breaker, wherein the determination comprises analysis of the plurality of spectral indicators or the plurality of spectral points; and
wherein the output unit is configured to output information relating to the indication of operational functionality of the circuit breaker.

9. System according to claim 8, wherein the determination of the vibration signal comprises segmentation of the frequency vibration data into a plurality of frequency sections; and wherein the determination of the plurality of spectral indicators or the plurality of spectral points comprises a determination of an energy of two or more frequency sections of the plurality of frequency sections.

10. System according to claim 8, wherein the determination of the plurality of spectral indicators or the plurality of spectral points comprises extraction of an amplitude and/or frequency of each local maximum and/or each local minimum of at least one local maximum and/or at least one local minimum of the vibration signal.

11. System according to any of claims 8-10, wherein the analysis of the plurality of spectral indicators or the plurality of spectral points comprises analysis of the plurality of spectral indicators or the plurality of spectral points by a machine learning algorithm, and wherein the machine learning algorithm was trained on a plurality of reference spectral indicators or a plurality of reference spectral points of a moveable contact with respect to a fixed contact over at least a portion of a plurality of reference opening operations of at least one reference circuit breaker determined from a plurality of reference temporal vibration data over the at least a portion of the plurality of the reference opening operations of the at least one reference circuit breaker, wherein the at least a portion of the reference opening operations comprised: movement of a moveable contact away from a fixed contact.

12. System according to any of claims 8-10, wherein the analysis of the plurality of spectral indicators or the plurality of spectral points comprises a comparison of the plurality of spectral indicators or the plurality of spectral points with a plurality of reference spectral indicators or a plurality of reference spectral points of a moveable contact with respect to a fixed contact over at least a portion of a plurality of reference opening operations of at least one reference circuit breaker determined from a plurality of reference temporal vibration data over the at least a portion of the plurality of the reference opening operations of the at least one reference circuit breaker, wherein the at least a portion of the reference opening operations comprised: movement of a moveable contact away from a fixed contact.

13. A circuit breaker monitoring method, comprising:
- acquiring, by a vibration sensor mounted to a circuit breaker, temporal vibration data over at least a portion of a closing operation of the circuit breaker, wherein the at least a portion of the closing operation comprises: movement of a moveable contact towards a fixed contact;
- providing, by the vibration sensor, the temporal vibration data to a processing unit;
- converting, by the processing unit, the temporal vibration data into frequency vibration data;
- determining, by the processing unit, a vibration signal based on the frequency vibration data;
- determining, by the processing unit, a plurality of spectral indicators or a plurality of spectral points based on the vibration signal;
- determining, by the processing unit, an indication of operational functionality of the circuit breaker, wherein the determination comprises analyzing the plurality of spectral indicators or the plurality of spectral points; and
- outputting, by an output unit, information relating to the indication of operational functionality of the circuit breaker.

14. A circuit breaker monitoring method, comprising:
- acquiring, by a vibration sensor mounted to a circuit breaker, temporal vibration data over at least a portion of an opening operation of the circuit breaker, wherein the at least a portion of the opening operation comprises: movement of a moveable contact away from a fixed contact;
- providing, by the vibration sensor, the temporal vibration data to a processing unit;
- converting, by the processing unit, the temporal vibration data into frequency vibration data;
- determining, by the processing unit, a vibration signal based on the frequency vibration data;
- determining, by the processing unit, a plurality of spectral indicators or a plurality of spectral points based on the vibration signal;
- determining, by the processing unit, an indication of operational functionality of the circuit breaker, wherein the determining comprises analyzing the plurality of spectral indicators or the plurality of spectral points; and
- outputting, by an output unit, information relating to the indication of operational functionality of the circuit breaker.

15. A switchgear comprising a system according to any of claims 1-7 or comprising a system according to any of claims 8-12.

16. A computer program element for controlling a system which when executed by a processor is configured to carry out the method of claim 13 or claim 14.
